# EUROPEAN PATENT SPECIFICATION

(11) **EP 1 758 154 B1**
(45) Date of publication and mention of the grant of the patent: **20.04.2016**
(21) Application number: 05745693.1
(22) Date of filing: 03.06.2005
(51) Int. Cl.: H01L 21/304

(54) **METHOD FOR PRODUCING SILICON WAFER**
HERSTELLUNGSVERFAHREN FÜR EINEN SILIZIUMWAFER
PROCÉDÉ DE FABRICATION D'UNE PLAQUE DE SILICIUM

(30) Priority: 15.06.2004 JP 2004176784
(43) Date of publication of application: 28.02.2007
(73) Proprietor: Shin-Etsu Handotai Co., Ltd., Tokyo (JP)
(72) Inventor: KIMURA, Akihiro, c/o Isobe R & D Center, Annaka-s hi, Gunma, 3790196 (JP)
(74) Representative: Wibbelmann, Jobst
(86) International application number: PCT/JP2005/010215
(87) International publication number: WO 2005/124843

(56) References cited:
- EP-A- 1 326 269
- EP-A- 1 391 921
- WO-A-01/52312
- JP-A- 9 260 314
- JP-A- 2001 015 459
- JP-A- 2003 257 981
- JP-A- 2004 071 836
- US-A- 6 043 156
- US-A1- 2003 104 698
- US-B1- 6 548 886

## Description

### Technical Field

The present invention relates to a method for producing a silicon wafer and a silicon wafer, particularly a method for producing a silicon wafer comprising a polishing step of polishing a silicon wafer and a heat treatment step of subjecting the silicon wafer to a heat treatment.

### Background Art

In recent years, as the circuit devices have become finer along with high integration of semiconductor circuits, quality requirement for silicon wafers to be substrates therefor produced by utilizing CZ method has been enhanced. In particular, in a silicon wafer, there is defect originating from single crystal growth degrading oxide dielectric breakdown voltage characteristic or device characteristic which is called as Grown-in defect such as, FPD (Flow Pattern Defect), LSTD (Laser Scattering Tomography Defect), and COP (Crystal Originated Particle). Reduction of density and size thereof has been emphasized.

Accordingly, as a wafer having few grown-in defects as described above, for example, there has been developed an epitaxial wafer in which a silicon layer is epitaxially grown newly on a general silicon wafer, an annealed wafer in which a heat treatment is performed in an atmosphere of hydrogen and/or argon at a high temperature, a wafer of an entire N region (dislocation cluster-free region outside OSF ring) produced by controlling crystal growth condition when a silicon single crystal is grown by CZ method, or the like.

Among them, an annealed wafer in which annealing is added to a substrate doped with nitrogen (hereinafter, occasionally referred to as nitrogen-doped annealed wafer) is a substrate developed by utilizing suppression effect of agglomeration of grown-in defects by nitrogen doping and promotion effect of oxygen precipitation thereby. In this nitrogen-doped annealed wafer, defect size is smaller by effect of nitrogen doping than that of a general crystal and also annihilation efficiency of defects in surface layer by annealing is improved, therefore grown-in defects in a wafer surface layer are reduced and also BMD (Bulk Micro Defect) density in the wafer bulk is high, and therefore, it is known that the wafer has effective gettering capability and is very useful. And, on the other hand, there has been a problem that when nitrogen concentration in a silicon single crystal is more than 1 x 10¹⁵ atoms/cm³, so-called OSF region is frequently contained in the wafer plane (see, for example, Iida et al., 46st Ouyoubuturigaku kankei rengou kouenkai 29a-ZB-9, and Inoue et al., 47st Ouyoubuturigaku kankei rengou kouenkai 30a-YM-8), distribution of grown-in defects does not become uniform in the wafer plane, and dispersion is generated in device characteristic in forming devices thereon, and therefore, yield is lowered.

Furthermore, with respect to nitrogen doping in a wafer, it has been known that for the purpose of suppressing generation of dislocation due to heat stress generated in a silicon single crystal substrate in a heat treatment in a high temperature region such as 1000 °C or more or for the purpose of preventing generation of crystal defect in single crystal growth, nitrogen is added in the growth of a silicon single crystal.

By the way, as integration of devices has become improved in recent years, flatness required generally for a silicon wafer has been strict, and as measures for improving flatness, it is thought that both sides of a silicon wafer are made to be mirror surfaces, and also that is made practicable partially. In particular, in a silicon wafer with a large diameter having a diameter of 300 mm or more that has been more demanded in recent years, flatness has become emphasized very much, and it has become essential to perform double-side polishing for improving flatness of the wafer.

However, in the case that such a double-side polished silicon wafer is subjected to, for example, a heat treatment at a high temperature for the purpose of reducing grown-in defects as described above, the wafer is held to a jig in a heat treatment apparatus at the heat treatment, and therefore, in a back surface of the silicon wafer, contact trace (scratch in the back surface) between the wafer and the jig has become formed. Such contact trace on a wafer back surface is not only undesired in appearance but also a factor causing defocus failure in an exposure step in device fabrication.

Moreover, a heat treatment as described above is generally performed to a mirror-polished wafer. However, in the case of subjecting a mirror wafer to a heat treatment as described above, silicon atoms in the wafer surface are rearranged and minute bump such as step or terrace becomes formed and haze is generated on the wafer surface after the heat treatment and occasionally surface state thereof has become worse than that of the mirror wafer before the heat treatment. Moreover, in the case that foreign body adheres on the wafer surface before the heat treatment, the foreign body comes to stick on the wafer surface by the heat treatment and even if the wafer is then cleaned, the foreign body cannot be removed and this has been not only undesired in appearance but also one factor causing yield lowering in forming devices. Furthermore, there has been a problem that in the case of producing a p-type silicon wafer doped with boron as the silicon wafer, when the heat treatment is performed, for example, in a hydrogen gas atmosphere, boron in the vicinity of the silicon wafer surface layer (region of approximately 5 µm from the wafer surface) evaporates, and boron concentration is lower as in nearer to the wafer surface and resistance of the wafer is changed.

Accordingly, for example, in a Japanese Patent Application Laid-open (kokai) No. 2004-71836, for removing contact trace or the like to be formed in the back surface of the wafer, there has been disclosed a method for producing a semiconductor substrate, at least comprising, a step of mirror-polishing a front surface of a semiconductor substrate, thereafter a step of heat-treating the semiconductor substrate by using a heat treatment apparatus, and a step of removing the back surface of the heat-treated semiconductor substrate by a predetermined amount. According to the Japanese Patent Application Laid-open (kokai) No. 2004-71836, it has been described that by removing only some amount of the back surface of the semiconductor substrate after the heat treatment with a conventional etching equipment or a conventional polishing equipment and so on, particle and scratch and so forth which stick on the back surface of the semiconductor substrate and which are caused by a substrate holding jig are removed, and therefore, generation of a defective product of semiconductor substrate or a defective product of device can be reduced.

However, by the Japanese Patent Application Laid-open (kokai) No. 2004-71836, scratch generated on the wafer back surface in the heat treatment can be removed by removing the back surface of the substrate after the heat treatment as described above. However, it has been impossible to solve the problem such as haze or foreign body sticking generated in a wafer front surface side.

Moreover, in addition, for example, in the Japanese Patent Application Laid-open (kokai) No. 2003-257981, there has been disclosed a method for producing a silicon wafer, comprising, a wafer slicing step of slicing wafers having a predetermined thickness from a silicon single crystal grown by Czochralski method, a lapping step of mechanically processing a front surface of the sliced wafer, an etching step of surface-treating the mechanically processed front surface of the wafer by chemical corrosion method, a heat treatment step of heating the wafer after the etching step at temperature of 1200 to 1300 °C for 1 to 24 hr, and a polishing step of mirror-polishing one side or both sides of the wafer after the heat treatment by mechano-chemical polishing method.

According to the Japanese Patent Application Laid-open (kokai) No. 2003-257981, it has been described that by polishing the wafer by 5-15 µm in one side thereof in the polishing step after the heat treatment step, boron concentration in the vicinity of a polished new surface layer can be constant by removing the surface layer vicinity in which boron concentration becomes low by causing boron drop-out in the heat treatment step, and furthermore, haze due to minute bump generated in the heat treatment step can be removed. Moreover, it has been described that in the case of both-side polishing after the heat treatment, contact trace caused with a support jig can be completely removed, and furthermore, an adhering body sticking on the wafer front surface can be removed.

However, in the case of subjecting the heat-treated wafer to mirror-polishing by polishing amount of 5-15 µm in one side thereof after subjecting actually a silicon wafer to a high-temperature heat treatment as described in the Japanese Patent Application Laid-open (kokai) No. 2003-257981, there has been a problem that a DZ layer (denuded zone layer) in a front surface thereof formed by the heat treatment bothers to become cut off entirely, and COP-free region in which COP does not exist cannot be sufficiently ensured in the surface layer of the produced silicon wafer, and oxide dielectric breakdown voltage characteristic of the wafer or device characteristic thereof is degraded.

WO 01/52312 A is directed to a manufacturing process which reduces COPs. The aim is to provide a simplified polishing process utilizing double side fine grinding and micro-etching, followed by annealing.

EP 1 326 269 A discloses that a CZ silicon single crystal wafer doped with nitrogen in a concentration of 1 x 10¹² to 5 x 10¹⁵ is subjected to a polishing and a subsequent heat treatment at a temperature of 1000-1200°C for 1 to 20 hours in Ar gas.

### Disclosure of the Invention

Accordingly, the present invention was conceived in view of the above problems. An object of the present invention is to provide a method for producing a silicon wafer by which a silicon wafer of high quality in which COP-free region or oxide precipitate-free region is sufficiently ensured and in which also neither haze nor foreign body sticking is on a wafer front surface and further in which no contact trace with a jig is on a wafer back surface can be produced.

In order to accomplish the above object, there is provided a method according to claim 1 for producing a silicon wafer from a silicon single crystal, at least comprising, a double-side polishing step of mirror-polishing both sides of a wafer sliced from the silicon single crystal, a heat treatment step of heat-treating the mirror-polished wafer, and a repolishing step of polishing again a front surface or the both sides of the heat-treated wafer.

By producing a silicon wafer by subjecting a wafer sliced from a silicon single crystal to, at least, the double-side polishing step, the heat treatment step, and the repolishing step of polishing again a front surface or the both sides of the wafer as described above, flatness of the wafer can be improved in the double-side polishing step, and then in the repolishing step, haze or foreign body sticking generated on a wafer front surface in the heat treatment step can be removed, further it becomes possible to remove easily contact trace with a jig that is formed on a wafer back surface. Furthermore, because the double-side polishing step is performed before the heat treatment step as described above, even if polishing amount in the repolishing step is made to be small, the wafer front surface can be easily a mirror again, and the polishing amount in the repolishing step can be small, and therefore, it is possible that denuded zone layer such as COP-free region or oxide precipitate-free region formed in a wafer surface layer in the heat treatment step is not annihilated in the repolishing step and is sufficiently ensured.

In the above case, nitrogen is doped in the silicon single crystal, and the concentration of the nitrogen doped in the silicon single crystal is 1 x 10¹³ - 1 × 10¹⁵ atoms/cm³

By doping nitrogen in a silicon single crystal as described above, suppression effect of agglomeration of grown-in defects and promotion effect of oxygen precipitation can be obtained, and therefore, annihilation efficiency of defects in surface layer is improved in performing the heat treatment step and COP-free region or oxide precipitate-free region can be easily formed to a deeper position of the wafer surface layer, and also, oxide precipitates are formed at high density in the wafer bulk, and thereby, silicon wafers having excellent gettering capability can be stably produced. In particular, if concentration of the nitrogen doped in the silicon single crystal is 1 x 10¹³ atoms/cm³ or more, suppression effect of agglomeration of grown-in defects and promotion effect of oxygen precipitation can be obtained significantly and therefore COP-free region or oxide precipitate-free region can be very stably formed, and also, when the nitrogen concentration is 1 x 10¹⁵ atoms/cm³ or less, OSF region is not formed in the wafer plane and distribution of the grown-in defects in the wafer plane can be uniform.

Moreover, in the heat treatment step, the mirror-polished wafer is heat-treated under an Ar atmosphere at temperature of 1100 °C to 1300 °C for 30 min to 24 hr.

In the heat treatment step, by heat-treating the mirror-polished wafer under an Ar atmosphere, for example, in the case that boron is doped in the silicon wafer, boron can be prevented from evaporating in the heat treatment, and therefore, boron drop-out becomes not to be caused in the wafer and it becomes unnecessary to consider the boron drop-out in determining polishing amount in the repolishing step. That is, even if the polishing amount in the polishing step after the heat treatment step is not made to be large 5-15 µm in one side as described in the Japanese Patent Application Laid-open (kokai) No. 2003-257981, boron concentration in the vicinity of the surface layer in the silicon wafer after the polishing can be constant. Moreover, by heat-treating the mirror-polished wafer at temperature of 1100 °C to 1300 °C for 30 min to 24 hr, for example, COP-free region or oxide precipitate-free region of approximately 5 µm or more can be efficiently formed stably in the surface layer of the silicon wafer.

Furthermore, the polishing amount of the wafer in the repolishing step is 1.5 nm to 4 µm in one side thereof.

When polishing amount of the wafer in the repolishing step is 1.5 nm or more in one side thereof, a front surface or both sides of the wafer after the heat treatment can be certainly mirror surface(s). Moreover, generally, haze generated on a wafer front surface in subjecting a silicon wafer to a heat treatment is approximately 1.5 nm in P-V value, and therefore, when polishing amount of the wafer is 1.5 nm or more in one side, haze can be certainly removed and also it becomes possible that foreign body sticking on the wafer front surface in the heat treatment step can be easily removed. Furthermore, frequently, contact trace with a jig formed on a wafer back surface is approximately 300 nm. For removing certainly the contact trace with a jig, it is more preferable that polishing amount is 300 nm or more in one side.

Moreover, when polishing amount of the wafer is 4 µm or less or further 3 µm or less in one side thereof as described above, it becomes possible that COP-free region or oxide precipitate-free region formed in a silicon wafer in the heat treatment step is stably ensured. For example, in the case of forming COP-free region or oxide precipitate-free region of approximately 5 µm or more in the heat treatment step as described above, when polishing amount of the wafer in the repolishing step is 4 µm or less in one side thereof, COP-free region or oxide precipitate-free region of at least approximately 1 µm or more can be certainly ensured in the silicon wafer after the repolishing step.

In the above case, the wafer to be produced can have a diameter of 300 mm or more.

In particular, high flatness has been required in a silicon wafer having a diameter of 300 mm or more having been more demanded in recent years. The method for producing a silicon wafer according to the present invention is very effective in the case of producing a silicon wafer with a large diameter having a diameter of 300 mm or more. According to the present invention, even in producing such a silicon wafer with a large diameter, COP-free region or oxide precipitate-free region can be sufficiently ensured, and also haze generated on a wafer front surface or foreign body sticking thereon or contact trace with a jig formed on a wafer back surface can be removed, and thereby, a wafer of high quality having high flatness can be produced.

And, according to the present invention, a silicon wafer produced by the above-described producing method of the present invention can be provided.

A silicon wafer produced according to the present invention as described above can be a wafer of high quality having high flatness in which COP-free region or oxide precipitate-free region is sufficiently ensured and in which also neither haze nor foreign body sticking is on a wafer front surface and further in which no contact trace with a jig is on a wafer back surface, and furthermore, it becomes possible that the wafer is uniform in grown-in defect distribution in the wafer plane.

As described above, according to the present invention, by performing the double-side polishing step and the heat treatment step and the repolishing step in order, flatness of the wafer can be improved in the double-side polishing step performed before the heat treatment step, and also haze or foreign body sticking on a wafer front surface and also contact trace with a jig on wafer back surface are removed by small polishing amount in the repolishing step performed after the heat treatment step, and thereby the wafer front surface can be easily a mirror surface. Therefore, a silicon wafer of high quality in which haze and foreign body sticking on a front surface or both sides of the wafer and further contact trace with a jig do not exist at all and in which COP-free region and oxide precipitate-free region are sufficiently ensured in the wafer surface layer and further which has high flatness can be stably produced.

### Brief Explanation of the Drawings

Fig. 1 is a flow chart showing an example of a method for producing a silicon wafer according to the present invention.
Fig. 2 is a schematic structure view showing an example of a double-side polishing apparatus having 4-way system.
Fig. 3 is a schematic plane view showing a planetary gear structure.

### Best Mode for Carrying out the Invention

Hereinafter, embodiments according to the present invention will be explained. However, the present invention is not limited thereto.

In conventional production of a silicon wafer, for removing haze or foreign body sticking generated on a wafer front surface in subjecting the silicon wafer to a heat treatment and also contact trace with a jig formed on a wafer back surface and further for removing influence of boron concentration lowering caused in subjecting the silicon wafer doped with boron to a heat treatment, for example, as the Japanese Patent Application Laid-open (kokai) No. 2003-257981, a polishing step in which one side or both sides is mirror-polished by mechano-chemical polishing method with respect to a silicon wafer after the heat treatment step has been performed.

However, in the case of performing mirror-polishing after the heat treatment step as described above, for making a wafer front surface a mirror surface by improving flatness of the wafer and further for removing influence of boron concentration lowering as described above, it is necessary that polishing amount in one side of the wafer is 5 µm or more. However, according to experiment by the present inventor, it has been found that if polishing is performed by polishing amount of 5 µm or more after the heat treatment step as described above, COP-free region or oxide precipitate-free region formed on a wafer front surface in the heat treatment is occasionally removed by the polishing. In particular, in the case of heat-treating a silicon wafer doped with nitrogen, it is necessary that nitrogen concentration in the single crystal is 1 x 10¹⁵ atoms/cm³ or less so that distribution of grown-in defects in the wafer plane becomes uniform. Therefore, with respect to COP-free region formed in the wafer surface layer in the heat treatment, only approximately 5 µm from the wafer front surface can be obtained at best. Therefore, it has been found that if polishing is performed by polishing amount of approximately 5-15 µm after the heat treatment step as the Japanese Patent Application Laid-open (kokai) No. 2003-257981, COP-free region of the silicon wafer to be finally obtained is also polished, and therefore occasionally, sufficient depth thereof cannot be ensured or the region is completely removed.

Accordingly, the present inventor has experimented and studied thoroughly with respect to a method for producing a silicon wafer in which haze or foreign body sticking generated on a wafer front surface and also contact trace with a jig formed on a wafer back surface can be easily removed and in which COP-free region and oxide precipitate-free region to be finally formed in the wafer surface layer can be sufficiently ensured. As a result, for removing haze and contact trace with a jig and so forth which are generated on the wafer after the heat treatment, it is clarified to be sufficient to perform polishing by polishing amount of approximately some nm to 300 nm. However, on the other hand, it has been found that a wafer front surface cannot be sufficiently made to be a mirror surface by such an extent as above polishing amount and also a level required from users with respect to flatness of the wafer cannot be satisfied. Accordingly, the present inventor has thought that a silicon wafer is preliminarily subjected to mirror-polishing before subjected to the heat treatment step and thereby flatness of the wafer is improved and also both sides of the wafer are once made to be mirror surfaces and that both sides or a front surface of the wafer may be polished again after the heat treatment step. Thereby, it has been found that polishing amount in polishing performed after the heat treatment step can be small, and as a result, COP-free region and oxide precipitate-free region to be finally formed in the silicon wafer can be sufficiently ensured and further haze generated on a wafer front surface of the wafer and foreign body sticking thereon and contact trace with a jig formed on a wafer back surface can be easily removed so that a front surface or both sides of the wafer become (s) mirror surface(s). Thereby, the present invention has been accomplished.

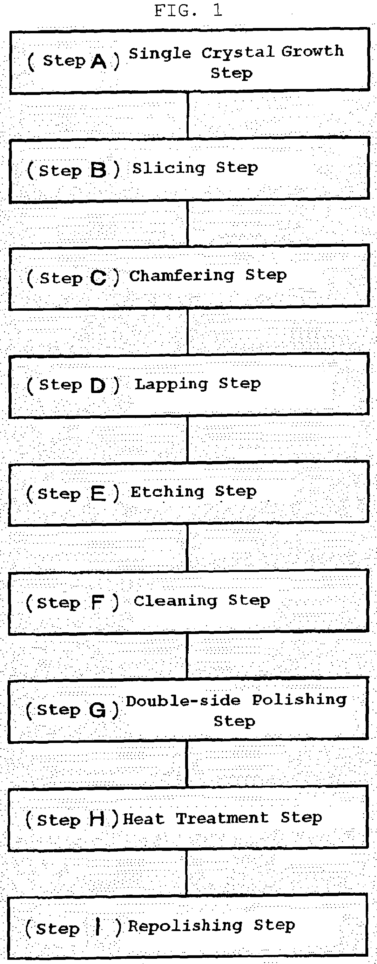

Hereinafter, a method for producing a silicon wafer according to the present invention will be explained in detail with reference to appended drawings. However, the present invention is not limited thereto at all. Here, Fig. 1 is a flow chart showing an example of a method for producing a silicon wafer according to the present invention.

As shown in Fig. 1, first, a silicon single crystal is grown by CZ method in a single crystal growth step (Step A), the grown silicon single crystal is sliced in a thin plate shape to produce wafers by using an inner diameter slicer apparatus or a wire saw or the like in a slicing step (Step B), then a chamfering step (Step C) of chamfering a wafer peripheral part for preventing crack or break of the wafer, a lapping step (Step D) of mechanically processing the wafer to improve flatness thereof, an etching step (Step E) of etching the wafer for removing mechanical damage or contaminant on the wafer, and a cleaning step (Step F) of cleaning the wafer subjected to the etching treatment, are performed in order. In addition, these steps are merely exemplified and cited, and the present invention is not limited at all and can be performed by being appropriately altered according to the purpose by modifying step order, by adding steps partially, by omitting, or the like.

In the above case, in the above-described single crystal growth step (Step A), it is preferable that in growing a silicon single crystal, nitrogen is doped in the silicon single crystal. The growth of the silicon single crystal doped with nitrogen can be performed by using, for example, a single crystal-pulling apparatus being generally used conventionally. As descried specifically, first, raw material polycrystalline silicon is charged in a quartz crucible provided in the single crystal-pulling apparatus and a predetermined amount of silicon wafer having nitride film is put therein. And, the raw material in the quartz crucible is heated with a heater to be raw material melt, and then a seed crystal held to a seed holder from above of the quartz crucible is immersed in the raw material melt, and then the seed crystal is calmly pulled upwardly with being rotated, and thereby a silicon single crystal doped with nitrogen can be grown.

By doping nitrogen in a silicon single crystal as described above, generation of grown-in defects in the single crystal growth can be suppressed and oxygen precipitation nuclei can be formed at high density in the silicon single crystal. Therefore, a wafer is sliced from the single crystal doped with nitrogen and then subjected to a heat treatment in a heat treatment step (Step H) as explained as follows, and thereby, defects existing in the wafer surface layer can be efficiently annihilated, and therefore, COP-free region or oxide precipitate-free region can be easily formed to a deeper position of the wafer surface layer and also oxide precipitates can be formed at high density in the wafer bulk, and therefore, it becomes possible that silicon wafers having excellent gettering capability is stably produced.

In the above case, suppression effect of agglomeration of grown-in defects by nitrogen doping as described above and promotion effect of oxygen precipitation thereby can be obtained in the case that nitrogen concentration in the single crystal is 1 x 10¹² - 5 x 10¹⁵ atoms/cm³, and in particular, that is significant in the case that the nitrogen concentration is 1 x 10¹³ atoms/cm³ or more. Therefore, it is preferable that concentration of the nitrogen doped in the silicon single crystal is 1 x 10¹³ atoms/cm³ or more, and thereby it becomes possible that COP-free region and oxide precipitate-free region can be stably formed in the wafer surface layer in the heat treatment afterward, for example, so that depth thereof becomes 5 µm or more.

On the other hand, when the nitrogen concentration in the single crystal is 1 x 10¹⁵ atoms/cm³ or less, OSF region is not formed in the wafer plane in producing a silicon wafer and therefore distribution of grown-in defects in the wafer plane can be uniform and improvement of yield in producing devices can be accomplished. Therefore, it is preferable that concentration of the nitrogen doped in the silicon single crystal is 1 x 10¹⁵ atoms/cm³ or less. In addition, it is more preferable that the nitrogen concentration in the single crystal is 5 x 10¹⁹ atoms/cm³ or less because the distribution of grown-in defects in the plane can be more uniform.

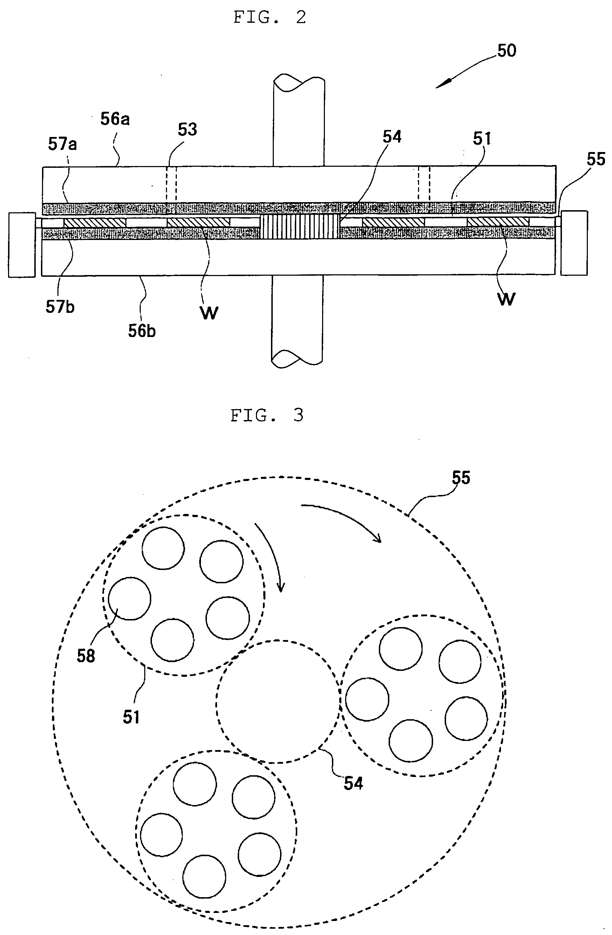

Next, the silicon wafer subjected to the steps of to the cleaning step as explained above is subjected to double-side polishing step (Step G in Fig. 1) of polishing both sides of the wafer. In this case, the method for subjecting a silicon wafer to double-side polishing is not particularly limited. However, for example, a silicon wafer W can be subjected to double-side polishing by using a so-called 4-way system double-side polishing apparatus 50 having plenary gear mechanism as shown in Fig.2 and Fig.3.

In the case of polishing a silicon wafer W by a double-side polishing apparatus 50 as shown in Fig. 2 and Fig. 3, the wafer W is inserted and held in a wafer-holding hole 58 formed plurally in a carrier 51. And, the wafer W in the holding hole is sandwiched between an upper turn table 56a and a lower turn table 56b on which polishing pads 57a, 57b are respectively attached, and polishing slurry is supplied through a slurry supply hole 53, and the carrier 51 is rotated and revolved between a sun gear 54 and an internal gear 55. Thereby, both sides of the wafer W in each of the holding holes can be polished at the same time.

By subjecting the silicon wafer to double-side polishing as described above, flatness of the wafer can be improved and a front surface and a back surface of the wafer can be mirror surfaces. In particular, a double-side polishing method of polishing both sides of the wafer at the same time is effective with respect to a silicon wafer with a large diameter having a diameter of 300 mm or more, and by subjecting such a wafer with a large diameter having a diameter of 300 mm or more to the double-side polishing, mirror-polished wafers with a large diameter having excellent flatness to the vicinity of the wafer peripheral end can be stably obtained.

After performing the double-side polishing step as described above, the heat treatment step of heat-treating the mirror-polished silicon wafer is performed (Step H in Fig. 1).

By heat-treating the silicon wafer whose both sides are mirror-polished as described above, crystal defects existing in the wafer surface layer of the silicon wafer are annihilated, and thereby COP-free region and oxide precipitate-free region are formed in the wafer surface layer and oxide precipitates with high density can be formed in the wafer bulk.

In this case, in the heat treatment step, the mirror-polished wafer is heat-treated under an Ar atmosphere at temperature of 1100 °C to 1300 °C for 30 min to 24 hr.

For example, in the case that boron is doped in the silicon wafer, if the wafer is heat-treated in a hydrogen atmosphere, the reaction "2B + 3H₂ → B₂H₆" is promoted in a wafer front surface and B₂H₆ is generated, and however the B₂H₆ is an evaporable substance whose vapor pressure is high and therefore there has been a problem that resistance of the wafer is changed due to boron drop-out from the vicinity of the wafer front surface as explained above in the heat treatment. However, by heat-treating the mirror-polished wafer under an Ar atmosphere as described above, even in the case that boron is doped in the silicon wafer, boron can be prevented from evaporating in the heat treatment and resistance of the wafer can be maintained to be uniform, and therefore, in determining polishing amount in the subsequent repolishing step, it becomes unnecessary that the polishing amount is increased more than it needs for considering the boron drop-out.

Moreover, when the heat treatment temperature in the heat treatment step is 1100 °C or more, crystal defects in the wafer surface layer can be annihilated very effectively and COP-free region and oxide precipitate-free region can be efficiently formed. On the other hand, if the heat treatment temperature is more than 1300 °C, it is feared to cause such a problem as deformation of the wafer or metal contamination, and therefore, it is preferable that the heat treatment temperature is 1100 °C to 1300 °C. Furthermore, when the heat treatment time is 30 min or more, for example, crystal defects existing in the region of a wafer front surface to approximately 5 µm or more can be annihilated, and the COP-free region of approximately 5 µm or more and the oxide precipitate-free region of approximately 20 µm or more can be stably formed in the wafer surface layer. On the other hand, it is thought that if the heat treatment is performed for more than 24 hr, deformation of the wafer due to oxygen precipitation effect becomes easily caused, and also by prolonging the heat treatment time, burden for cost becomes large and that is not economical, and therefore, it is preferable that the heat treatment time is 24 hr or less.

In addition, by performing this heat treatment step, as usual, haze or foreign body sticking is generated on a front surface of the silicon wafer, and also, on a wafer back surface, contact trace is formed in a contact part thereon with a jig of a heat treatment apparatus.

And, after performing the above-described heat treatment step, the repolishing step of repolishing again a front surface or the both sides of the heat-treated wafer (Step I in Fig. 1).

In this case, with respect to the silicon wafer, the both sides of the wafer has been preliminarily mirror-polished before the heat treatment step and flatness thereof has been improved, and therefore, polishing amount in the repolishing step can be small, and when a front surface or the both sides of the heat-treated wafer is mirror-polished again by small polishing amount, even if haze or foreign body sticking generated on a wafer front surface or contact trace formed on a wafer back surface is generated by any possibility in the above-described heat treatment step, they can be easily removed, therefore, the wafer front surface can be mirror-polished. Furthermore, in the present invention, because polishing amount in the repolishing step can be small as describe above, COP-free region and oxide precipitate-free region formed in the wafer surface layer in the heat treatment step can be sufficiently ensured without being annihilated by the polishing.

In this case, the polishing amount of the wafer in the repolishing step is 1.5 nm to 4 µm in one side thereof.

In the present invention, double-side polishing has been preliminarily performed, and therefore, when polishing amount of the wafer in the repolishing step is 1.5 nm or more in one side thereof, a front surface or the both sides of the wafer can be certainly mirror surface(s). Furthermore, in general, haze generated in a wafer front surface in heat-treating the silicon wafer as described above is approximately 1.5 nm in P-V value, and therefore, when the polishing amount in one side is 1.5 nm or more, the haze generated on a wafer front surface in the heat treatment can be certainly removed, and also, it becomes possible that foreign body sticking on a wafer front surface in the heat treatment step can be easily removed. Furthermore, it is frequent that contact trace with a jig formed on a back surface of the wafer in the heat treatment step is approximately 300 nm, and therefore, in the case of performing double-side polishing in the repolishing step, when polishing amount of the wafer is 300 nm or more in one side thereof, contact trace formed on the wafer back surface can be certainly removed.

Moreover, on the other hand, COP-free region and oxide precipitate-free region formed in the heat treatment step are, for example, approximately 5 µm or more as described above, and therefore, when polishing amount of the wafer in the repolishing step is 4 µm or less or further 3 µm or less in one side thereof, COP-free region and oxide precipitate-free region remaining in the silicon wafer after the repolishing step can be certainly ensured as depth of 1 µm or more, or further, 2 µm or more.

By producing a silicon wafer as described above, a mirror-polished wafer of high quality having high flatness in which COP-free region or oxide precipitate-free region is sufficiently ensured and in which also neither haze nor foreign body sticking is on a wafer front surface and further in which no contact trace with a jig is on a wafer back surface can be stably produced. Furthermore, because the silicon wafer according to the present invention can be doped with nitrogen by a predetermined concentration, the wafer can be uniform in distribution of grown-in defects in the wafer plane.

In particular, the producing method according to the present invention is very effective in the case of producing a silicon wafer with a large diameter having a diameter of 300 nm or more, and according to the present invention, silicon wafers of high quality with a large diameter in which COP-free region or oxide precipitate-free region is sufficiently ensured and in which haze, foreign body sticking, and contact trace with a jig do not exist and further which have high flatness can be stably produced.

Hereinafter, the present invention will be explained more specifically with reference to Examples and Comparative examples. However, the present invention is not limited thereto.

### (Example 1)

Silicon wafers were produced based on the flow chart as shown in Fig. 1.

First, in the single crystal growth step (Step A), a silicon single crystal having a diameter of 300 mm and a nitrogen concentration of 5 x 10¹³ atoms/cm³ was grown by CZ method. In the slicing step (Step B), the grown silicon single crystal is sliced by using a wire saw and thereby a plurality of wafers were produced.

Out of them, three wafers neighboring to each other were selected and these three wafers were subjected to the chamfering step, the lapping step, the etching step, and the cleaning step (Steps C to F) in order. Next, the obtained three silicon wafers were subjected to the double-side polishing step (Step G) by using the double-side polishing apparatus 50 as shown in Fig. 2, and then, the mirror-polished three silicon wafer were set in a vertical heat treatment furnace and subjected to a heat treatment under an Ar atmosphere at 1200 °C for 1 hr (Step H).

Then, with respect to one (wafer "a") out of the obtained three wafers, COP in a wafer front surface was measured by Particle counter SP-1 (manufactured by KLA-Tencor Co., Ltd.). Next, the front surface of the wafer "a" was polished by 1 µm and COP in the polished wafer front surface was measured again. Such measurement of COP was repeated until the total of the polishing amount of the wafer "a" becomes 10 µm, and thereby depth distribution of COP in the range of the wafer front surface to 10 µm was obtained. In addition, the polishing amount of the wafer was estimated from difference of the wafer thicknesses before and after polishing which were measured by Capacitance type contact-free thickness meter CL-250 (manufactured by Ono Sokki Co., Ltd.).

Moreover, with respect to another wafer (wafer "b") out of the three wafer produced as described above, oxygen precipitation heat treatment was performed at 800 °C for 4 hr + at 1000 °C for 16 hr, and then, oxygen precipitation characteristic in the wafer plane was evaluated by X-ray topography. Furthermore, then, BMD density and depth of oxide precipitate-free region was obtained by subjecting the wafer "b" to angle polishing and etching.

Furthermore, with respect to the other one (wafer "c") out of the three wafers produced as described above, the repolishing step was performed so that polishing amount of the wafer front surface was 4 µm and so that polishing amount of the wafer back surface was 500 nm (Step I).

Here, the measurement result of measuring COP depth distribution of the wafer "a" is shown in Table 1 as follows. As shown in Fig. 1, the COP number of the wafer "a" was less than 10 in the region of the wafer front surface to 5 µm. However, the COP number was sharply increased when depth from the wafer front surface becomes more than 5 µm. As a result, the COP-free region formed in the silicon wafer subjected to the steps of to the heat treatment step in Example 1 was estimated to be in the range of the wafer front surface to 5 µm.

**(Table 1)**

| Depth from Wafer Front Surface (µm) | COP number (pcs/wafer) |
|---|---|
| 0 | 7 |
| 1.2 | 5 |
| 2.5 | 8 |
| 3.8 | 4 |
| 5.1 | 8 |
| 6.2 | 96 |
| 7.6 | 248 |
| 8.7 | 375 |
| 10.1 | 548 |

Next, from the evaluation result of the wafer "b" by X-ray topography, it was confirmed that the BMD density was uniform in the wafer plane. Furthermore, it was found that the BMD density in the wafer central part obtained by performing angle polishing and etching was 5.4 x 10⁵ /cm² (5.4 x 10⁹ /cm³ as converted to volume density), and moreover, depth of BMD-free region formed in the wafer surface layer was 24 µm.

From these results of the wafers "a" and "b", it was found that with respect to the silicon wafer "c" as a final product obtained by performing the repolishing step, COP-free region was 1 µm and BMD-free region was 20 µm. Furthermore, a front surface and a back surface of the wafer "c" to be a final product was measured by Particle counter SP-1, and thereby, it was possible to confirm that haze in the front surface of the wafer "c" was the approximately same as that of a mirror wafer and also contact trace with a jig of a heat treatment apparatus in the wafer back surface was not observed and was completely removed. In addition, with respect to the silicon wafer "c" in Example 1, by mirror-polishing the both sides before the heat treatment, the back surface also became a mirror surface although repolishing amount of the wafer back surface was small of 500 nm.

From the result as described above, with respect to the silicon wafer "c" produced in Example 1, it was possible to confirm that device active region of 1 µm being defect-free in both COP and BMD was ensured in the wafer surface layer and that region being excellent in gettering capability in which oxide precipitates were formed at high density was ensured in the wafer bulk, and it was found that the wafer can be supplied as being applicable for device fabrication.

### (Example 2)

Three silicon wafers were subjected to the steps of to the heat treatment step (Step H) in the same manner as the above-described Example 1 except that the concentration of doped nitrogen was 2 x 10¹⁵ atoms/cm³ in growing a silicon single crystal by CZ method by the single crystal growth step (Step A). And then, by using these three silicon wafers, depth distribution of COP, BMD characteristic, and surface states of the both front and back surfaces of the wafer to be a final product were evaluated in the same manner as the above-described Example 1.

As a result, COP-free region in the wafer subjected to the steps of to the heat treatment step in Example 2 was in the range of the wafer front surface to 15 µm, and therefore, it was found that COP-free region in the silicon wafer to be a final product was 11 µm, larger than that of Example 1. Moreover, it was possible to confirm that haze in the front surface of the silicon wafer to be a final product was the approximately same as that of a mirror wafer and also contact trace with a jig of a heat treatment apparatus was completely removed in the wafer back surface and the surface became a mirror surface.

On the other hand, as a result of measuring BMD density and BMD-free region of the wafer subjected to the steps of to the heat treatment in Example 2, BMD density in the wafer central part was approximately 2.4 x 10¹⁰ /cm³ and BMD-free region therein was 20 µm (16 µm in a final product). However, in the wafer peripheral part in which the oxygen precipitation was found to be small from the result by X-ray topography, the density was approximately 2.8 x 10⁷ /cm³, and thereby, it was confirmed that defect distribution in the wafer plane has some amount of bias. It is thought that this was caused because the concentration of nitrogen doped in the single crystal was somewhat high.

### (Comparative example 1)

After a silicon single crystal was grown by CZ method in the single crystal growth step (Step A) in the same condition as the above-described Example 1, the slicing step (Step B) was performed, and then, two wafers neighboring to each other were selected and these two wafers were subjected to the chamfering step, the lapping step, the etching step, and the cleaning step (Steps C to F) in order.

Next, without being polished, the obtained two silicon wafers were set in a vertical heat treatment furnace and heat-treated under an Ar atmosphere at 1200 °C for 1 hr, and then with respect to the heat-treated wafer, the both sides of the wafer was subjected to mirror-polishing by 5 µm in each side thereof.

Then, with respect to one wafer out of the obtained two wafers, oxygen precipitation heat treatment was performed at 800 °C for 4 hr + at 1000 °C for 16 hr, and then, BMD density and depth of oxide precipitate-free region were measured.

Moreover, with respect to the other wafer, surface states of the both front and back surfaces in the wafer were evaluated by measurement by Particle counter SP-1, and then, depth distribution of COP in the range of the wafer front surface to 10 µm in the silicon wafer was measured in the same manner as the above-described Example 1.

As a result, with respect to the silicon wafer (the wafer after the mirror polishing) produced in Comparative example 1, it was found that BMD density thereof was uniform in the wafer plane, and BMD density in the wafer central part was approximately 5.4 x 10⁹ /cm³ and size of BMD-free region therein was 19 µm. Moreover, with respect to the silicon wafer of Comparative example 1, it was possible to confirm that haze on the wafer front surface was the approximately same as that of a mirror wafer and also contact trace with a jig of a heat treatment apparatus in the wafer back surface was completely removed and the surface became a mirror surface. However, as a result of measuring depth distribution of COP, it was found that in the silicon wafer of Comparative example 1, COP-free region did not exist at all and also surface state of the wafer front surface did not reach a level required from users and thereby the wafer was not applicable for device fabrication.

### (Comparative example 2)

Two silicon wafers were produced in the same manner as the above-described Comparative example 1 except that polishing amount of mirror-polishing performed after the heat treatment was 4 µm in each of the sides thereof in the above-described Comparative example 1.

Then, with respect to one wafer out of the obtained two wafers, BMD density and depth of oxide precipitate-free region were measured in the same manner as the above-described Comparative example 1, and moreover, with respect to the other wafer, surface states of the both front and back surfaces of the wafer were evaluated and then depth distribution of COP in the range of the wafer front surface to 10 µm in the silicon wafer was measured.

As a result, with respect to the silicon wafer (the wafer after the mirror polishing) produced in Comparative example 2, it was found that BMD density thereof was uniform in the wafer

plane, and BMD density in the wafer central part was approximately 5.4 x 10⁹ /cm³ and size of BMD-free region therein was 20 µm and furthermore COP-free region of 1 µm was ensured. Furthermore, with respect to the silicon wafer of Comparative example 2, it was possible to confirm that haze on the wafer front surface was the approximately same as that of a mirror wafer and also contact trace with a jig of a heat treatment apparatus in the wafer back surface was completely removed. However, by measuring surface state of the wafer front surface, it was found that the surface state did not reach a level required from users and thereby the wafer was not applicable for device fabrication.

For example, in the above-described embodiments, the case of producing a silicon wafer having a diameter of 300 mm was exemplified and explained. However, the present invention is not limited thereto and is applicable in the same manner in the case of producing a silicon wafer having a diameter of 100-400 mm or more. In the description of the heat treatment step, the case of heat-treating a wafer by using a vertical furnace is exemplified. However, it goes without saying that the present invention is applicable in the same manner in the case of using a horizontal furnace.

## Claims

1. A method for producing a silicon wafer from a silicon single crystal doped with nitrogen at a concentration of 1 x 10¹³ - 1 x 10¹⁵ atoms/cm³, the method at least comprising a double-side polishing step of mirror-polishing with polishing pads and polishing slurry both sides of a wafer sliced from the silicon single crystal, a heat treatment step of heat-treating the mirror-polished wafer under an Ar atmosphere at temperature of 1100 °C to 1300 °C for 30 min to 24 hr, and a repolishing step of polishing again a front surface or the both sides of the heat-treated wafer, wherein polishing amount of the wafer in the repolishing step is 1.5 nm to 4 µm in one side thereof.

2. The method for producing a silicon wafer according to claim 1, wherein the wafer to be produced has a diameter of 300 mm or more.

## Patentansprüche

1. Verfahren zum Herstellen eines Silizium-Wafers aus einem Silizium-Einkristall, der mit Stickstoff bei einer Konzentration von 1 x 10¹³ - 1 x 10¹⁵ Atome/cm³ dotiert ist, wobei das Verfahren mindestens einen beidseitigen Polierschritt des Hochglanzpolierens mit Polierpads und Polierschmiere beider Seiten des aus dem Silizium-Einkristall geschnittenen Wafers, einen Hitzebehandlungsschritt des Hitzebehandelns des hochglanzpolierten Wafers in einer Ar-Atmosphäre bei einer Temperatur von 1100°C bis 1300°C für 30 Minuten bis 24 Stunden, und einen Nachpolierschritt des Wiederpolierens einer vorderen Oberfläche oder beider Seiten des hitzebehandelten Wafers, wobei die Poliermenge des Wafers in dem Nachpolierschritt 1,5 nm bis 4 µm in einer Seite davon beträgt, umfasst.

2. Verfahren zum Herstellen eines Silizium-Wafers nach Anspruch 1,
wobei der herzustellende Wafer einen Durchmesser von 300 mm oder mehr aufweist.

## Revendications

1. Procédé de production d'une plaquette de silicium à partir d'un monocristal de silicium dopé à l'azote à une concentration de 1 x 10¹³ à 1 x 10¹⁵ atomes/cm³, le procédé comprenant au moins une étape de polissage double face de polissage miroir avec des tampons de polissage et une pâte de polissage des deux côtés d'une plaquette découpée en tranches à partir du monocristal de silicium, une étape de traitement thermique de traitement thermique de la plaquette au poli miroir sous une atmosphère d'argon (Ar) à une température de 1 100°C à 1 300°C pendant 30 min à 24 h, et une étape de repolissage de polissage à nouveau d'une surface avant ou des deux côtés de la plaquette traitée thermiquement, dans lequel la quantité de polissage de la plaquette à l'étape de repolissage est de 1,5 nm à 4 µm sur un côté de celle-ci.

2. Procédé de production d'une plaquette de silicium selon la revendication 1, dans lequel la plaquette à produire a un diamètre de 300 mm ou plus.
